# EUROPEAN PATENT APPLICATION

(11) **EP 4 811 937 A1**
(43) Date of publication of application: **23.09.2026**
(21) Application number: 24894014.0
(22) Date of filing: 07.11.2024
(51) Int. Cl.: H05K 1/18, H01L 23/12, H05K 3/28, H05K 3/34

(54) **CIRCUIT BOARD AND METHOD FOR MANUFACTURING MOUNTING BOARD**

(30) Priority: 21.11.2023 JP 2023197369
(71) Applicant: TDK Corporation, Tokyo 103-6128 (JP)
(72) Inventor: UEMATSU, Hiroyuki, Tokyo 103-6128 (JP); WADA, Yukari, Tokyo 103-6128 (JP); TANIGUCHI, Susumu, Tokyo 103-6128 (JP)
(74) Representative: Epping - Hermann - Fischer
(86) International application number: PCT/JP2024/039688
(87) International publication number: WO 2025/110022

(57) **Abstract**

A circuit board includes a base material having a main surface, a first terminal and a second terminal provided on the main surface of the base material, and one or more walls of an insulating material provided on the main surface of the base material, wherein the first and second terminals are arranged in a cavity surrounded by the wall, and at least one of corner portions formed from two wall frame portions among the walls has a groove portion penetrating from an inner peripheral surface to an outer peripheral surface.

## Description

### Technical Field

The present disclosure relates to a circuit board, and a method for manufacturing a mounting board.

### Background Art

In recent years, electronification has progressed, and accordingly, development of technology for mounting electronic components on a board is progressing. For example, technology for mounting a large number of bare chips of semiconductor light-emitting elements represented by light-emitting diodes (hereinafter, referred to as "LEDs") used for lighting, display devices, and the like on a wiring board has been developed. For example, Patent Literature 1 discloses an invention in which a semiconductor light-emitting element is inserted into and bonded within a cavity capable of easily positioning and arranging a plurality of semiconductor light-emitting elements. Also, in Patent Literature 2, in electronic component mounting using a paste-like bonding material, technology for suppressing bringing-back of a semiconductor light-emitting element and solder bridging has also been developed.

### Citation List

### Patent Literature

Patent Literature 1: Japanese Unexamined Patent Publication 2006-93523
Patent Literature 2: Japanese Unexamined Patent Publication 2004-47772

### Summary of Invention

### Technical Problem

Here, in a circuit board, a terminal and a bonding material may be arranged inside a wall of an insulating material. With respect to such a circuit board, there is a case where an electronic component is mounted by filling the inside of the wall with a constituent material, mounting the electronic component using a holding member, pushing the electronic component into the inside of the wall using a pressurized reflow apparatus, heating, and bonding to the circuit board. At this time, due to a surplus constituent material staying in the wall and at an upper part of the wall around the electronic component, the electronic component cannot be sufficiently pushed in in a pressurizing step using the pressurized reflow apparatus, and there is a possibility that a connection failure between the bonding material of the circuit board and the electronic component occurs. Also, it is required to improve positional accuracy in the circuit board of the electronic component to be mounted.

An object of the present disclosure is to provide a circuit board and a method for manufacturing a mounting board capable of suppressing a connection failure between the circuit board and an electronic component and improving positional accuracy of the mounted electronic component.

### Solution to Problem

A circuit board according to the present disclosure is a circuit board comprising a base material having a main surface, a first terminal and a second terminal provided on the main surface of the base material, and one or more walls of an insulating material provided on the main surface of the base material, wherein the first and second terminals are arranged in a cavity surrounded by the wall, and at least one of corner portions formed from two wall frame portions among the walls has a groove portion penetrating from an inner peripheral surface to an outer peripheral surface.

A method for manufacturing a mounting board according to the present disclosure is for manufacturing a mounting board by mounting an electronic component on the above-described circuit board, wherein a constituent material may be arranged on the base material, the electronic component may be arranged, and thereafter the electronic component may be bonded to the terminal using a pressurized reflow apparatus.

### Advantageous Effects of Invention

According to the present disclosure, it is possible to provide a circuit board and a method for manufacturing a mounting board capable of suppressing a connection failure between the circuit board and an electronic component and improving positional accuracy of the mounted electronic component.

### Brief Description of Drawings

FIG. 1 is a schematic cross-sectional view showing a mounting board including an example of a circuit board according to an embodiment of the present disclosure.
FIG. 2 is a schematic cross-sectional view showing an example of the circuit board according to the embodiment of the present disclosure.
FIG. 3 is a plan view of the circuit board.
FIGS. 4(a) and 4(b) are plan views of a circuit board according to a modification.
FIGS. 5(a), 5(b), and 5(c) are views of a wall frame portion of a wall viewed from a thickness direction.
FIGS. 6(a) and 6(b) are views showing an example of a groove portion having roundness.
FIGS. 7(a), 7(b), and 7(c) are plan views showing modifications of the groove portion.
FIG. 8 is a view for explaining an area of the groove portion.
FIGS. 9(a) and 9(b) are views for explaining a width and a length of the groove portion.
FIGS. 10(a) and 10(b) are cross-sectional views showing a structure in the vicinity of a depression portion.
FIGS. 11(a), 11(b), and 11(c) are schematic views showing an example of a method for manufacturing the circuit board and the mounting board.
FIG. 12 is a schematic view showing an example of the method for manufacturing the circuit board and the mounting board.
FIGS. 13(a), 13(b), 13(c), 13(d), 13(e), and 13(f) are schematic views showing an example of a method for manufacturing a wall portion.
FIG. 14 is a schematic cross-sectional view showing a circuit board according to a comparative example.
FIGS. 15(a) and 15(b) are plan views for explaining a concave portion.

### Description of Embodiments

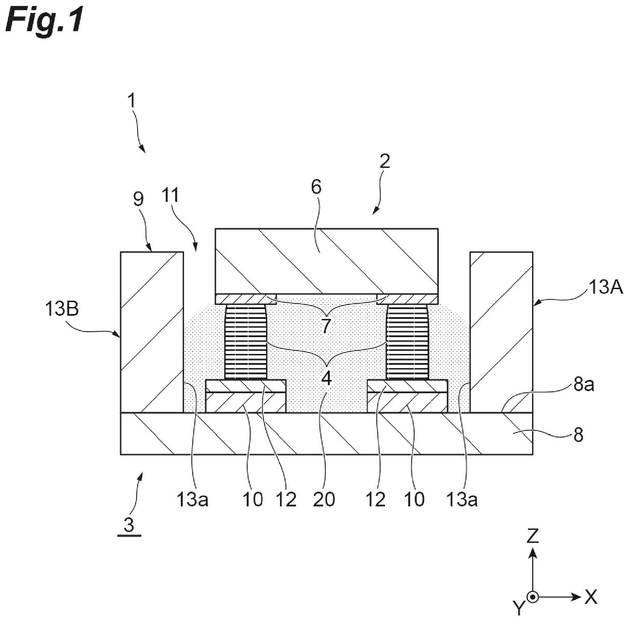

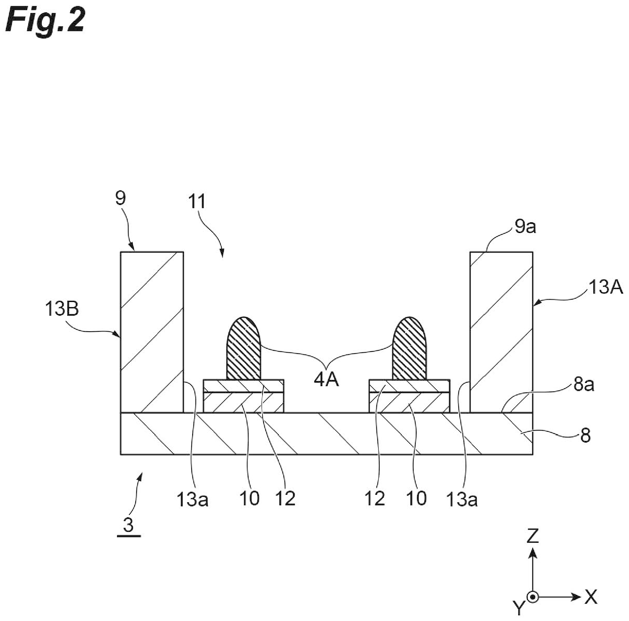

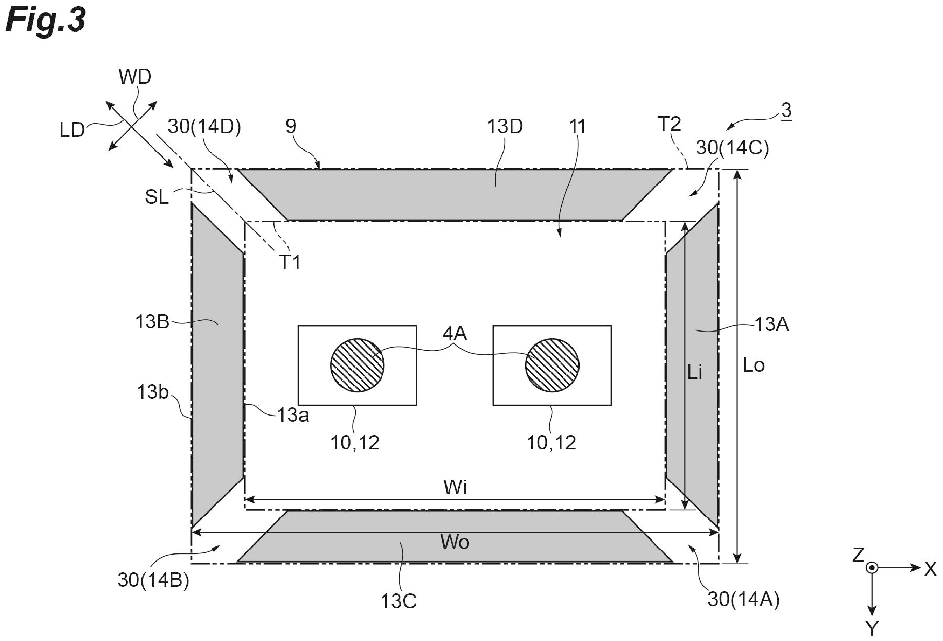

A circuit board 3 according to an embodiment of the present disclosure will be described with reference to FIGS. 1 to 3. Fig. 1 is a schematic cross-sectional view showing a mounting board 1 including an example of the circuit board 3 according to the embodiment of the present disclosure. Fig. 2 is a schematic cross-sectional view showing an example of the circuit board 3 according to the embodiment of the present disclosure. Fig. 3 is a plan view of the circuit board 3.

As shown in FIG. 1, the mounting board 1 includes an electronic component 2 and a circuit board 3. The mounting board 1 is configured by mounting the electronic component 2 on the circuit board 3 via a bonding material 4.

The electronic component 2 includes a main body portion 6 and a pair of terminals 7. The main body portion 6 is a member for exhibiting a function as the electronic component 2. The terminal 7 is a metal portion formed on a main surface of the main body portion 6. As a material of the terminal 7, a metal of Cu, Ti, Au, Ni, Sn, Bi, P, B, In, Ag, Zn, Pd, Mo, Pt, Cr, an alloy selected from at least two of these, or the like is adopted. The electronic component 2 is configured by, for example, a micro LED or the like. The micro LED is a component that emits light in response to an input from the circuit board 3.

The circuit board 3 includes a base material 8, a wall 9, and a pair of terminals 10 (a first terminal and a second terminal). The base material 8 is a flat plate-shaped main body portion of the circuit board 3. The base material 8 has a main surface 8a. As the base material 8, a printed board for mounting each conductor pattern and each electronic component in the circuit board 3 on the main surface 8a may be adopted. As a material of the base material 8, a known resin material or ceramic material used for a printed board may be adopted. In the following description, description may be made using XYZ coordinates set for the circuit board 3. An X-axis direction (second direction) is a direction parallel to the main surface 8a of the base material 8, a Y-axis direction (third direction) is a direction parallel to the main surface 8a of the base material 8 and orthogonal to the X-axis direction, and a Z-axis direction (first direction, height direction) is a direction orthogonal to the main surface 8a of the base material 8.

The wall 9 of an insulating material is provided on the main surface 8a of the base material 8. The wall 9 is a member formed of an insulating material. The wall 9 is convex from the base material 8 toward a positive side in the Z-axis direction. As shown in FIG. 3, in the present embodiment, the wall 9 has wall frame portions 13A, 13B, 13C, and 13D provided on four sides. The wall frame portions 13A and 13B face each other in a state of being separated from each other in the X-axis direction, and extend parallel to the Y-axis direction. The wall frame portion 13A is arranged on the positive side in the X-axis direction, and the wall frame portion 13B is arranged on the negative side. The wall frame portions 13C and 13D face each other in a state of being separated from each other in the Y-axis direction, and extend parallel to the X-axis direction. The wall frame portion 13C is arranged on the positive side in the Y-axis direction, and the wall frame portion 13D is arranged on the negative side. The wall frame portion 13A connects ends on the positive side in the X-axis direction of the wall frame portions 13C and 13D to each other. The wall frame portion 13B connects ends on the negative side in the X-axis direction of the wall frame portions 13C and 13D to each other. Thereby, the wall 9 has a rectangular frame-shaped structure when viewed from the height direction. The wall frame portions 13A and 13B constitute short sides, and the wall frame portions 13C and 13D constitute long sides. Although dimensions are not particularly limited, dimensions in the Y-axis direction of the wall frame portions 13A and 13B may be set to 10 µm to 60 µm. Dimensions in the X-axis direction of the wall frame portions 13C and 13D may be set to 15 µm to 70 µm. A dimension of a short side of an inner peripheral surface inside the wall 9 may be set to 8 µm or more and 44 µm or less. A dimension of a long side of the inner peripheral surface inside the wall 9 may be 15 µm or more and 68 µm or less. The dimension of the short side of the inner peripheral surface inside the wall 9 is a dimension in the Y-axis direction between an inner peripheral surface 13a of the wall frame portion 13C and an inner peripheral surface 13a of the wall frame portion 13D. The dimension of the long side of the inner peripheral surface inside the wall 9 is a dimension in the X-axis direction between an inner peripheral surface 13a of the wall frame portion 13A and an inner peripheral surface 13a of the wall frame portion 13B. As a material of the wall 9, for example, a resin material such as an epoxy resin, an acrylic resin, a phenol resin, a melamine resin, a urea resin, an alkyd resin, or the like is adopted. Particularly preferably, as the material of the wall 9, an epoxy resin or an acrylic resin is adopted.

As shown in Figs. 1 to 3, the terminal 10 is a metal portion provided on the main surface 8a of the base material 8. As a material of the terminal 10, Ni, Cu, Ti, Cr, Al, Mo, Pt, Au, an alloy selected from at least two of these, or the like is adopted. A conductive film 12 is formed on an upper surface of the terminal 10. As a material of the conductive film 12, a film of Ti, Cu, Ni, Al, Mo, Cr, Ag, or the like, or a film in which metal particles and a binder are mixed, or the like is adopted.

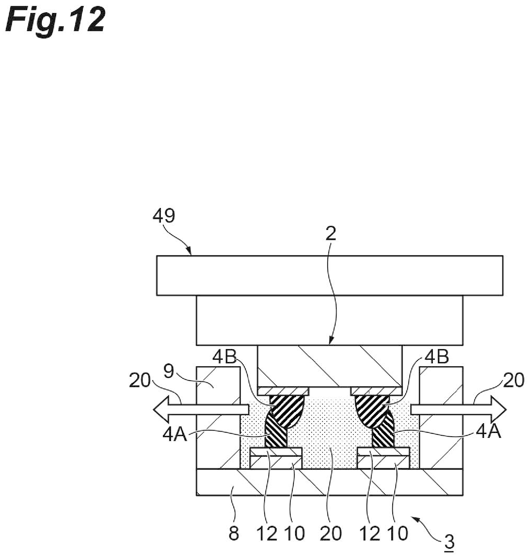

The bonding material 4 is a member that bonds the terminal 7 of the electronic component 2 and the terminal 10 of the circuit board 3. The bonding material 4 is configured by thermally bonding and integrating a bonding material 4A on the circuit board 3 side and a bonding material 4B on the electronic component 2 side (see Fig. 12). The bonding material 4 may contain Sn, or may be composed of an alloy containing Sn. However, the bonding material 4 is not necessarily limited to one containing Sn. The bonding material 4 may be composed of an alloy containing an element that lowers the melting point of Sn, in addition to Sn. As the element that lowers the melting point of Sn, for example, Bi or the like can be cited. The bonding material 4 functions as solder. Thereby, between the base material 8 and the main body portion 6, the terminal 10, the conductive film 12, the bonding material 4, and the terminal 7 are laminated in this order from the upper surface of the base material 8. In addition, at this location, solder bonding is performed after the terminal 10, the conductive film 12, the bonding material 4, and the terminal 7 are laminated. Therefore, after solder bonding, a structure in which respective metals of the terminal 10, the conductive film 12, the bonding material 4, and the terminal 7 are melted and diffused is formed. Such a structure after solder bonding may be a structure containing a brittle intermetallic compound (IMC). When an intermetallic compound which is a brittle structure exists, since it becomes easy to break due to stress from the outside, reliability tends to decrease. Therefore, by surrounding the electronic component 2 with the wall 9, an effect of protecting the electronic component 2 appears.

A cavity 11 is formed in the wall 9. The cavity 11 is configured by a through hole penetrating the wall 9 in the height direction. Thereby, on the bottom side of the cavity 11, the upper surface of the base material 8 is exposed. The cavity 11 has a rectangular shape when viewed from the height direction (see Fig. 3). The terminal 7, the terminal 10, the conductive film 12, and the bonding material 4 are surrounded by the wall 9 by being arranged in the cavity 11 surrounded by the wall 9. A slight gap is formed between the terminal 7, the terminal 10, the conductive film 12, and the bonding material 4, and the inner peripheral surfaces 13a of the wall frame portions 13A, 13B, 13C, and 13D on four sides constituting the cavity 11.

In the cavity 11, a constituent material 20 is arranged between the electronic component 2 and the bonding material 4, and the wall 9. Thereby, by supporting with the constituent material 20, it is possible to make the electronic component 2 difficult to peel off from the circuit board 3. Also, force applied to the electronic component 2, the bonding material 4, and the terminals 7 and 10 is relaxed, and reliability can be improved. As a material of the constituent material 20, for example, an epoxy resin, an acrylic resin, a phenol resin, a melamine resin, a urea resin, an alkyd resin, a mixture thereof, or a mixture of the resin material and SiOx, ceramics, or the like is adopted. Particularly preferably, as the material of the constituent material 20, an epoxy resin or an acrylic resin is adopted. The viscosity of the constituent material 20 at the time of filling is preferably 1 Pa to 20 Pa, and more preferably 5 Pa to 10 Pa.

As shown in Fig. 2, the circuit board 3 has a configuration in which the electronic component 2 and the constituent material 20 are removed from the mounting board 1 shown in Fig. 1. In the circuit board 3, the bonding material 4A containing a metal element is arranged on the upper side of the terminal 10 (upper surface of the conductive film 12). The circuit board 3 includes the bonding material 4A (first bonding material) on the positive side in the X-axis direction arranged on the terminal 10A, and the bonding material 4A (second bonding material) on the negative side in the X-axis direction arranged on the terminal 10B. These bonding materials 4A constitute a part of the bonding material 4 in a stage before thermally bonding the electronic component 2 and the mounting board 1, as described above. In the state of the circuit board 3, the pair of terminals 10, the conductive film 12, and the bonding material 4A are arranged in the wall 9 formed of an insulator.

As shown in Fig. 3, the rectangular frame-shaped wall 9 has four corner portions 14A, 14B, 14C, and 14D by having the wall frame portions 13A, 13B, 13C, and 13D provided on four sides. The corner portion 14A is formed from the wall frame portions 13A and 13C. The corner portion 14B is formed from the wall frame portions 13B and 13C. The corner portion 14C is formed from the wall frame portions 13A and 13D. The corner portion 14D is formed from the wall frame portions 13B and 13D. At least one of the corner portions 14A, 14B, 14C, and 14D has at least one groove portion 30 penetrating from the inner peripheral surface 13a to the outer peripheral surface 13b.

A rectangular reference shape T1 having a minimum area circumscribing the inner peripheral surface 13a of the cavity 11 of the wall 9 when viewed from the height direction (first direction) is set. A rectangular reference shape T2 having a maximum area inscribing the outer peripheral surface 13b of the wall 9 when viewed from the height direction is set. In the present embodiment, the reference shapes T1 and T2 are rectangular shapes. These reference shapes T1 and T2 are virtually set, and are shown by virtual lines in Fig. 3. A line connecting corner portions of the virtual reference shapes T1 and T2 is defined as a reference line SL. In the present embodiment, the groove portion 30 may extend along a direction in which the reference line SL extends. The groove portion 30 extends along an extension direction LD. In the present embodiment, the direction in which the reference line SL extends and the extension direction LD are parallel, but they do not have to be parallel. The definition of the extension direction LD will be described later. For example, in the example shown in Fig. 3, the groove portion 30 includes both the corner portion of the reference shape T1 and the corner portion of the reference shape T2, but the groove portion 30 may have a shape that does not include the corner portion of the reference shape T2. For example, as a countermeasure for strength, the groove portion 30 may have a shape that does not include the corner portion of the reference shape T2 by shifting an end portion on the outer peripheral side of the groove portion 30 toward the wall frame portions 13C and 13D on the long side. In the following description, the direction in which the reference line SL extends when viewed from the height direction may be referred to as an "extension direction LD" in which the groove portion 30 extends. Also, a direction orthogonal to the extension direction LD and the height direction (Z-axis direction) may be referred to as a width direction WD of the groove portion 30. In Fig. 3, the extension direction LD and the width direction WD for the corner portion 14D are shown, but directions to the same effect are defined for the other corner portions 14. The groove portion 30 penetrates the wall 9 so as to include the position of the corner portion of the reference shape T1 on the inner peripheral side and the position of the corner portion of the reference shape T2 on the outer peripheral side. Note that the groove portion 30 only needs to include at least one of the corner portion of the reference shape T1 and the corner portion of the reference shape T2 when viewed from the height direction. Therefore, the groove portion 30 does not have to include both of the reference shapes T1 and T2.

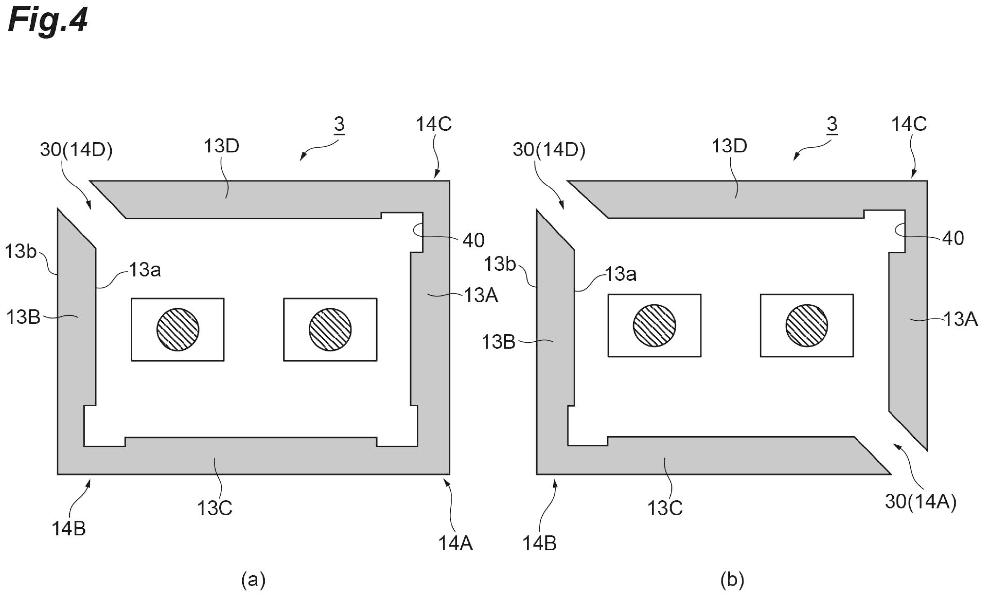

Note that at least one of the corner portions 14A, 14B, 14C, and 14D may have the groove portion 30. For example, as shown in Figs. 4(a) and 4(b), one of the four corner portions 14A, 14B, 14C, and 14D may have the groove portion 30. Although the corner portion 14D has the groove portion 30 in the figure, another corner portion may have the groove portion 30.

Also, at least a pair of corner portions on a diagonal may have the groove portion 30. By providing depressions in the pair of corner portions 14 on the diagonal, the surplus constituent material 20 can be flowed to the groove portions 30 in a well-balanced manner. The pair of corner portions 14 on the diagonal are a combination of the corner portions 14A and 14D, and a combination of the corner portions 14B and 14C. Although the combination of the corner portions 14A and 14D has the groove portion 30 in the figure, the combination of the corner portions 14B and 14C may have the groove portion 30.

Among the corner portions 14, at least one of the corner portions 14 not having the groove portion 30 may have a concave portion 40 recessed toward the outer peripheral side from the inner peripheral surface 13a. The concave portion 40 has a shape recessed toward the outer peripheral side in the inner peripheral surface 13a of the cavity 11 of the wall 9 when viewed from the height direction (Z-axis direction in the present embodiment). The concave portion 40 extends from the inner peripheral surface 13a toward the outer peripheral surface 13b side, but does not penetrate to the outer peripheral surface 13b. In the figure, all of the corner portions 14 where the groove portion 30 is not formed have the concave portion 40, but some of the corner portions 14 may have the concave portion 40.

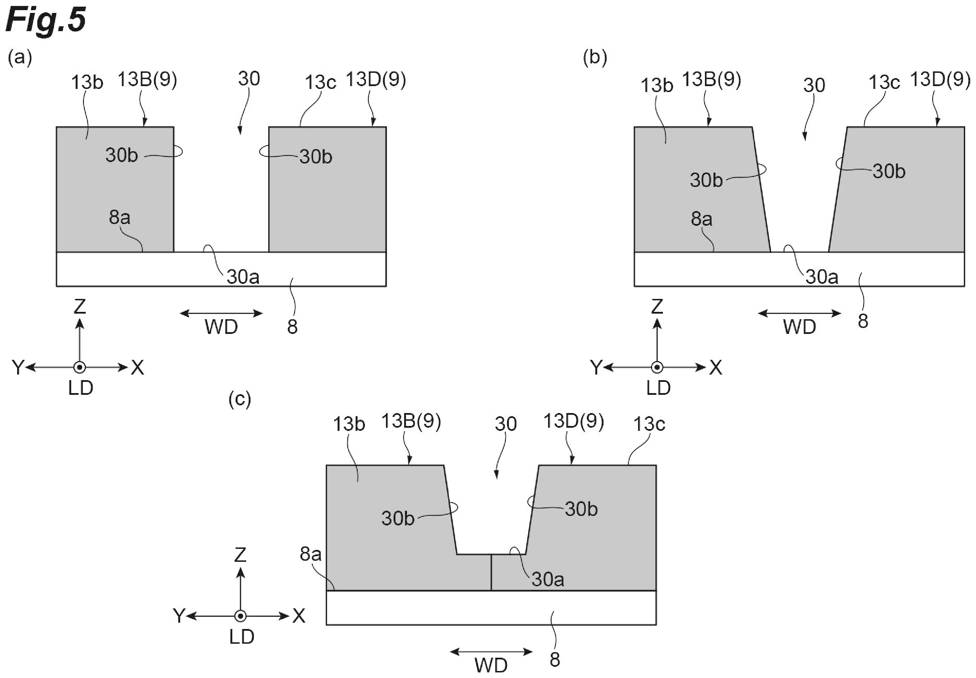

Next, a configuration when the groove portion 30 is viewed from the extension direction LD (see also Fig. 3) will be described with reference to Fig. 5. an (a) part of Fig. 5 is a view of the corner portion 14D between the wall frame portion 13B and the wall frame portion 13D viewed from the extension direction LD. Although the corner portion 14D is shown in (a), (b), and (c) parts of Fig. 5, description to the same effect holds true for the other corner portions 14A, 14B, and 14C. As shown in (a) part of Fig. 5, when viewed from the extension direction LD, the groove portion 30 extends from a tip portion 13c in the height direction (Z-axis direction in the present embodiment) of the wall frame portions 13B and 13D toward the base material 8 side (negative side in the Z-axis direction). The groove portion 30 has a bottom surface 30a and a pair of side surfaces 30b. The bottom surface 30a is formed on the negative side in the Z-axis direction relative to the tip portion 13c. The pair of side surfaces 30b extend from both end portions of the bottom surface 30a to the tip portion 13c. In the example shown in (a) part of Fig. 5, the groove portion 30 reaches the main surface 8a of the base material 8. In this case, the bottom surface 30a of the groove portion 30 is constituted by the main surface 8a of the base material 8. In this configuration, the wall frame portion 13B and the wall frame portion 13D are divided by the groove portion 30.

As shown in Fig. 5(b), the width of the groove portion 30 in the width direction WD is larger on the tip portion 13c side than on the bottom surface 30a side. The width of the groove portion 30 at the tip portion 13c is larger than the width of the groove portion 30 at the bottom surface 30a. In the example shown in Fig. 5(b), the groove portion 30 opens largely in the width direction WD toward the tip portion 13c side. The pair of side surfaces 30b are inclined such that a separation distance from each other increases toward the positive side in the Z-axis direction.

As shown in (c) part of Fig. 5, the bottom surface 30a of the groove portion 30 may be arranged at a position separated from the base material 8. Members of the wall frame portions 13B and 13D exist between the bottom surface 30a and the main surface 8a of the base material 8.

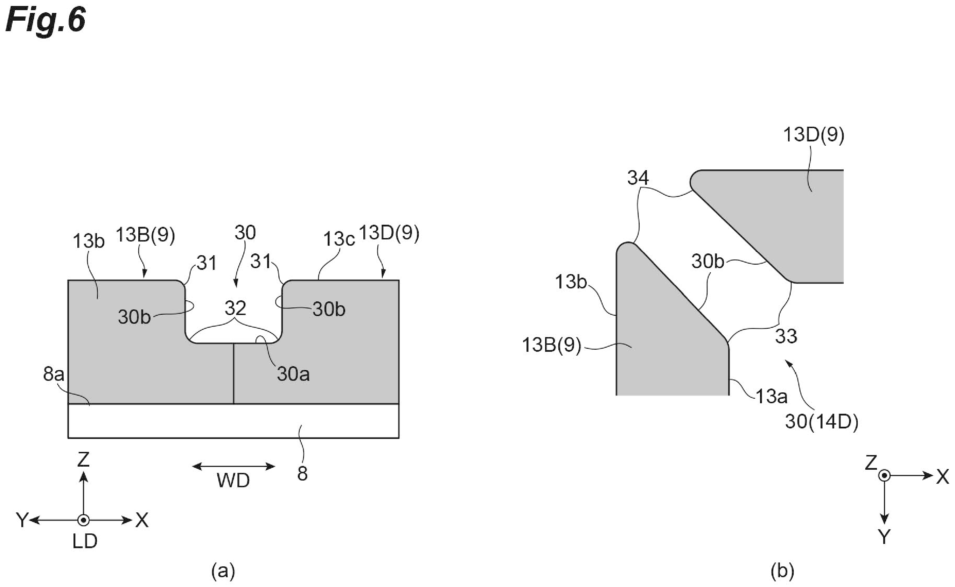

As shown in (a) and (b) parts of Fig. 6, roundness (corner R) is given to an edge portion of the groove portion 30. As shown in (a) part of Fig. 6, roundness is given to an edge portion 31 between the tip portion 13c and the side surface 30b. Roundness is given to an edge portion 32 between the bottom surface 30a and the side surface 30b. As shown in (b) part of Fig. 6, roundness is given to an edge portion 33 between the inner peripheral surface 13a and the side surface 30b. Roundness is given to an edge portion 34 between the outer peripheral surface 13b and the side surface 30b.

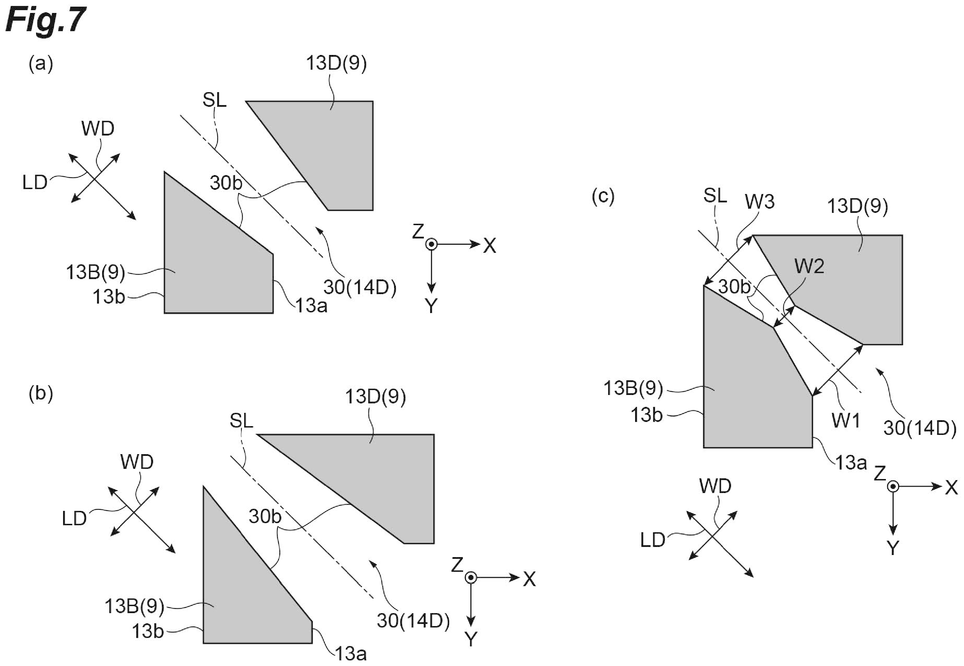

As shown in (a) and (b) parts of Fig. 7, when viewed from the height direction, regarding the width of the groove portion 30 in the width direction WD orthogonal to the extension direction LD of the groove portion 30 and the height direction, one of the outer peripheral side and the inner peripheral side may be larger than the other. For example, in the example shown in (a) part of Fig. 7, the width of the groove portion 30 increases from the inner peripheral side toward the outer peripheral side. The separation distance in the width direction WD between the side surfaces 30b on both sides increases toward the outer peripheral side. In this case, the width of the groove portion 30 is larger on the outer peripheral side than on the inner peripheral side. In the example shown in (b) part of Fig. 7, the width of the groove portion 30 increases from the outer peripheral side toward the inner peripheral side. The separation distance in the width direction WD between the side surfaces 30b on both sides increases toward the inner peripheral side. In this case, the width of the groove portion 30 is larger on the inner peripheral side than on the outer peripheral side.

As shown in (c) part of Fig. 7, when viewed from the height direction, regarding the width of the groove portion 30 in the width direction WD orthogonal to the extension direction LD of the groove portion 30 and the height direction, when a width on the inner peripheral side is W1, a width at an intermediate position in the extension direction LD is W2, and a width on the outer peripheral side is W3, one of "W1, W3 ≥ W2, W3 ≥ W1" or "W1, W3 ≥ W2, W1 ≥ W3" may hold true. W1 is an opening width at the inner peripheral surface 13a of the groove portion 30. W3 is an opening width at the outer peripheral surface 13b of the groove portion 30. W2 is a minimum width among widths of the groove portion 30 in the extension direction LD between the inner peripheral surface 13a and the outer peripheral surface 13b. Further detailed description of the width of the groove portion 30 will be described later. The relationship "W1, W3 ≥ W2" means that the width at the intermediate position in the extension direction LD is equal to or less than the opening widths on the inner peripheral side and the outer peripheral side. Since either the opening width on the outer peripheral side or the opening width on the inner peripheral side may be larger or they may be the same, "W3 ≥ W1" or "W1 ≥ W3" holds true.

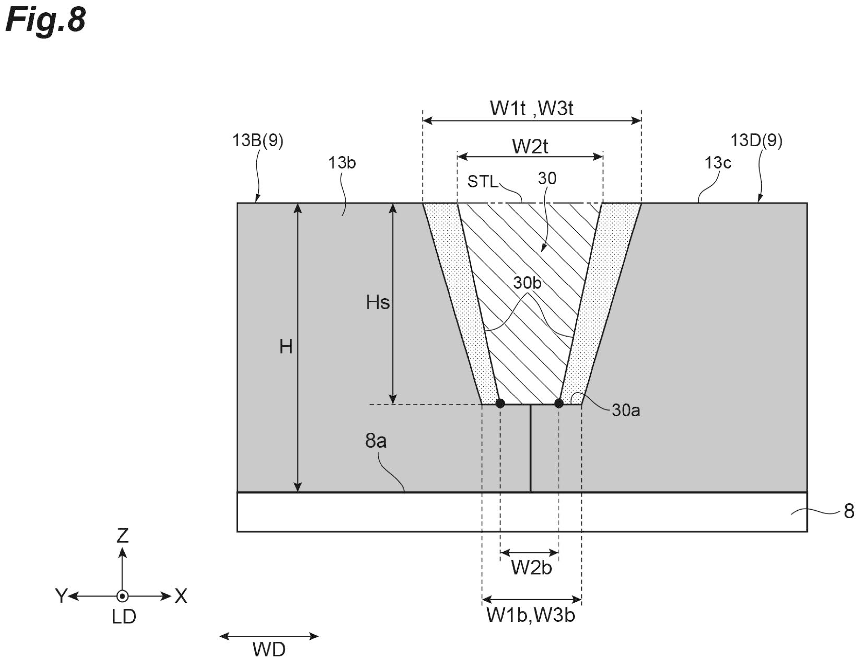

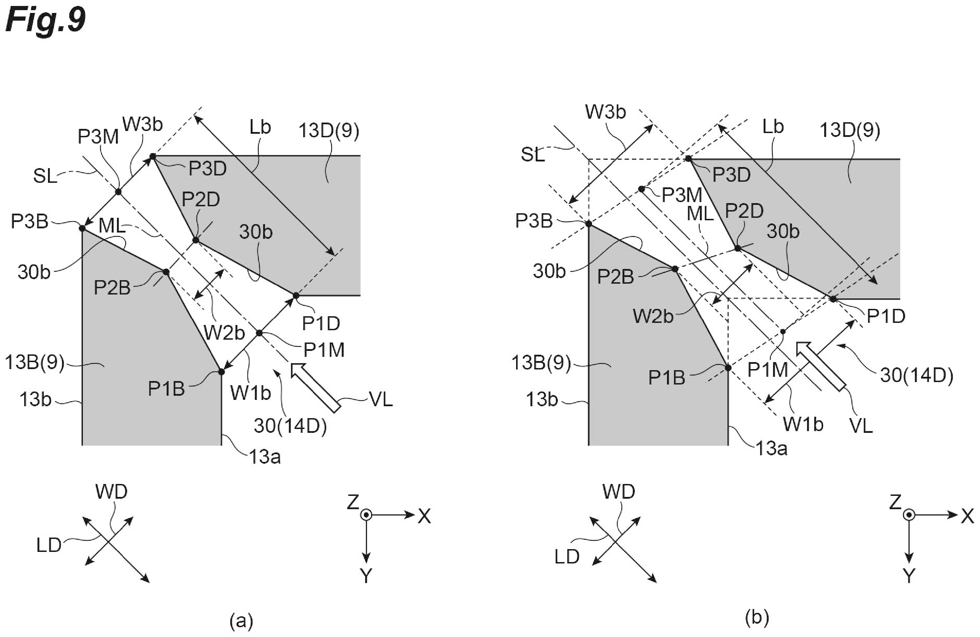

Next, the size of the groove portion 30 will be described in more detail with reference to Fig. 3, Fig. 8, and (a) and (b) parts of Fig. 9. Referring to Fig. 3, a sum of areas of the inner peripheral surfaces 13a of the wall frame portions 13A, 13B, 13C, and 13D when viewed from the thickness direction of the wall frame portions 13A, 13B, 13C, and 13D in the wall 9 is defined as S. For the wall frame portions 13A and 13B, the X-axis direction is the thickness direction. The width of the wall frame portions 13A and 13B when viewed from the thickness direction is the length of the short side of the reference shape T1, and is indicated by Li. For the wall frame portions 13C and 13D, the Y-axis direction is the thickness direction. The width of the wall frame portions 13C and 13D when viewed from the thickness direction is the length of the long side of the reference shape T1, and is indicated by Wi. Let the height of the wall 9 be H (see Fig. 8). At this time, the area S is obtained by multiplying the sum of the widths of the wall frame portions 13A, 13B, 13C, and 13D by the height H of the wall 9. That is, it is obtained by the following formula (3). Note that the widths on the outer peripheral side of the wall 9 are defined as Wo and Lo. $S = \left(Wi+Wi+Li+Li\right) \times H$

Next, dimensions related to the groove portion 30 will be described with reference to Fig. 8 and (a) and (b) parts of Fig. 9. Here, as shown in Fig. 7(c), an example in which the width becomes smallest at an intermediate position in the extension direction LD will be described. When the constituent material 20 passes through the groove portion 30, the influence of the narrowest portion when viewed from the extension direction LD becomes large, so the influence of the portion corresponding to the width W2 (see (c) part of Fig. 7) becomes large. As shown in Fig. 8, among the widths of the bottom surface 30a of the groove portion 30 in the width direction WD, a width corresponding to the width W2 at the intermediate position is defined as W2b, a width corresponding to the width W1 of the opening portion on the inner peripheral side is defined as W1b, and a width corresponding to the opening portion on the outer peripheral side is defined as W3b. Among the widths of the tip portion 13c of the groove portion 30 in the width direction WD, a width corresponding to the width W2 at the intermediate position is defined as W2t, a width corresponding to the width W1 of the opening portion on the inner peripheral side is defined as W1t, and a width corresponding to the opening portion on the outer peripheral side is defined as W3t. A length of the groove portion 30 in the extension direction LD at the bottom surface 30a of the groove portion 30 is defined as Lb (see Figs. 9(a) and 9(b)).

Here, the widths W1b, W2b, W3b, and the length Lb will be described in more detail with reference to (a) and (b) parts of Fig. 9. Each dimension is set based on a line of sight VL when viewing the groove portion 30 from the inside of the wall 9 toward a direction along the extension direction LD. Note that description to the same effect holds true for the widths W1t, W2t, W3t, and the length Lt at the tip portion 13c. Fig. 9(a) illustrates a configuration in which the side surface 30b on the wall frame portion 13B side and the side surface 30b on the wall frame portion 13D side are symmetric with respect to the reference line SL. Among the side surface 30b on the wall frame portion 13B side, locations defining the respective widths W1b, W2b, and W3b are defined as points P1B, P2B, and P3B. Among the side surface 30b on the wall frame portion 13D side, locations defining the respective widths W1b, W2b, and W3b are defined as points P1D, P2D, and P3D. The extension direction LD is set as follows. First, a line segment connecting a midpoint P3M between the point P3B and the point P3D and a midpoint P1M between the point P1B and the point P1D when viewed from the height direction is defined as a line segment ML. At this time, the length of the line segment ML is defined as "length Lb". Also, a direction parallel to the line segment ML is defined as the extension direction LD of the groove portion 30. A direction orthogonal to the line segment ML when viewed from the height direction is defined as the width direction WD. A distance between a straight line passing through the point P2B and parallel to the extension direction LD and a straight line passing through the point P2D and parallel to the extension direction LD is defined as "width W2b". A distance between a straight line passing through the point P3B and parallel to the extension direction LD and a straight line passing through the point P3D and parallel to the extension direction LD is defined as "width W3b". A distance between a straight line passing through the point P1B and parallel to the extension direction LD and a straight line passing through the point P1D and parallel to the extension direction LD is defined as "width W1b".

In the form shown in (a) and (b) parts of Fig. 9, the line segment connecting the points P1B and P1D, the line segment connecting the points P2B and P2D, and the line segment connecting the points P3B and P3D are all orthogonal to the reference line SL. Therefore, the separation distance between the points P1B and P1D when viewed from the height direction becomes equal to the width W1b in the width direction WD. The separation distance between the points P2B and P2D when viewed from the height direction becomes equal to the width W2b in the width direction WD. The separation distance between the points P3B and P3D when viewed from the height direction becomes equal to the width W3b in the width direction WD. The length Lb of the groove portion 30 at the bottom surface 30a is set by a distance in the extension direction LD between the points P1B, P1D and the points P3B, P3D.

The (b) part of Fig. 9 illustrates a configuration in which the side surface 30b on the wall frame portion 13B side and the side surface 30b on the wall frame portion 13D side are asymmetric with respect to the reference line SL. Here, the side surface 30b on the wall frame portion 13D side is arranged at a position farther from the reference line SL than the side surface 30b on the wall frame portion 13B side. In this case, the line segment connecting the points P1B and P1D, the line segment connecting the points P2B and P2D, and the line segment connecting the points P3B and P3D are not orthogonal to the reference line SL. Therefore, the separation distance between the points P1B and P1D when viewed from the height direction becomes larger than the width W1b in the width direction WD. The separation distance between the points P2B and P2D when viewed from the height direction becomes larger than the width W2b in the width direction WD. The separation distance between the points P3B and P3D when viewed from the height direction becomes larger than the width W3b in the width direction WD. Also for the form of Fig. 9(b), the line segment ML, the extension direction LD, and the width direction WD are set, and the widths W1b, W2b, W3b, and the length Lb are set by the same procedure as that described in (a) part of Fig. 9. Note that (a) and (b) parts of Fig. 9 are merely examples of the shape of the side surface 30b, and various shapes can be adopted.

As shown in Fig. 8, an opening area of the groove portion 30 when viewed from the extension direction LD of the groove portion 90 in the wall 9 is defined as Sc. The opening area Sc is a portion indicated by hatching in Fig. 8. The opening area Sc is an area of a region surrounded by the side surfaces 30b, the bottom surface 30a, and a reference line STL which is a virtual line extending the tip portion 13c, when viewed from the extension direction LD. The opening area Sc is defined by a line segment drawn by a location arranged on the innermost side in the width direction WD among the side surfaces 30b on both sides in the width direction WD. Let the depth of the groove portion 30 be Hs. The opening area Sc shown in Fig. 8 is obtained by the following formula (4). However, in the case of a configuration as in (a) part of Fig. 5 or (a) part of Fig. 6, calculation for obtaining the opening area Sc corresponding to each structure may be performed. Note that the lower limit value of the dimension of the width W2b corresponding to the minimum width of the groove portion 30 is not particularly limited, but may be, for example, 1 µm or more, and may be 4 µm or more. Note that the upper limit value may be set within a range satisfying formulas (1) and (2) described later. Also, when the bottom surface 30a is arranged at a position separated from the base material 8, the bottom surface 30a may have a curved shape. $Sc = \left\{\left(W2t+W2b\right)\times Hs\right\} / 2$

A relationship of the following formula (1) holds between the area S of the wall frame portions 13A, 13B, 13C, and 13D obtained as described above and the opening area Sc. Also, as described above, when the width of the bottom surface 30a of the groove portion 30 in the width direction WD is W2b, and the length of the groove portion 30 in the extension direction LD at the bottom surface 30a of the groove portion 30 is Lb, the following formula (2) holds. Note that "n" in formula (2) means the total number of groove portions 30 that the wall 9 has. In the form shown in Fig. 3, since there are four groove portions 30, "n = 4". Also, for example, in the example shown in Figs. 7(a) and 7(b), the dimension of the narrower width among the opening portions on the inner peripheral side and the outer peripheral side becomes "W2b". $0.004 \leq Sc / S < 0.6$ $0.1 \leq Σ \left(W2bn/Lbn\right) < 21.5$

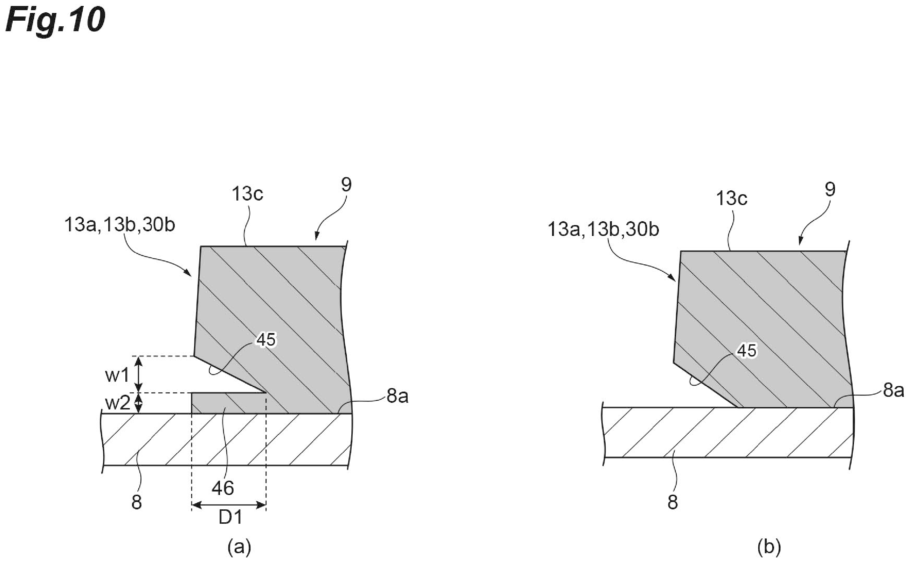

Here, as shown in Fig. 10(a), any of surfaces extending in the height direction of the wall 9 may have a depression portion 45 at a position on the base material 8 side in the height direction, and a cavity material 46 covering the base material 8 may be provided at the position of the depression portion 45. The surfaces extending in the height direction in the wall 9 are the inner peripheral surface 13a, the outer peripheral surface 13b, and the side surface 30b of the groove portion 30. Any of these surfaces 13a, 13b, and 30b only needs to have the depression portion 45. Also, the depression portion 45 does not have to be provided in the entire area of each of the surfaces 13a, 13b, and 30b, and may be provided in a part thereof. The depression portion 45 is formed at a position closer to the base material 8 than the tip portion 13c in the height direction. The depression portion 45 is formed at a position separated upward from the main surface 8a of the base material 8. Therefore, the cavity material 46 is formed between the depression portion 45 and the main surface 8a of the base material 8. The depression portion 45 may extend in a direction in which the surfaces 13a, 13b, and 30b extend along the planar direction of the base material 8. For example, when the inner peripheral surface 13a of the wall frame portion 13A has the depression portion 45, the depression portion 45 may be formed so as to extend in the Y-axis direction. Also, when the side surface 30b of the groove portion 30 of the corner portion 14D has the depression portion 45, the depression portion 45 may be formed so as to extend in the extension direction LD (see Fig. 3).

The opening width of the depression portion 45, that is, the size of the dimension w1 of the opening portion in the height direction is not particularly limited, but may be set to 0 µm or more and 3 µm or less. The thickness of the cavity material 46, that is, the size of the dimension w2 in the height direction is not particularly limited, but may be set to 0 µm or more and 1 µm or less. The dimension D1 of the depth of the depression portion 45 is not particularly limited, but may be set to 0 µm or more and 3 µm or less. In the example shown in Fig. 10(b), the depression portion 45 is formed at the position of the base material 8, and the cavity material 46 is not formed. Since such a structure lowers the bonding strength between the wall 9 and the base material 8, the structure of Fig. 10(a) is preferable. However, the structure as in (b) part of Fig. 10 is not excluded.

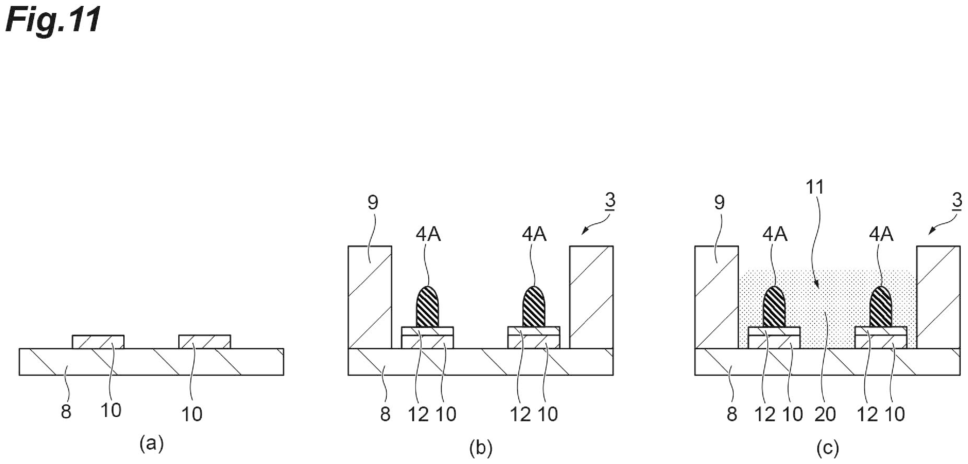

A method for manufacturing the circuit board 3 and the mounting board 1 will be described with reference to (a), (b), and (c) parts of Fig. 11 and Fig. 12. First, as shown in Fig. 11(a), the terminal 10 is formed on the upper surface of the base material 8. Next, as shown in (b) part of Fig. 11, the wall 9 is formed on the base material 8. Thereby, the circuit board 3 is completed. In (b) part of Fig. 11, the conductive film 12 and the bonding material 4A are formed on the upper surface of the terminal 10. Next, as shown in Fig. 11(c), the constituent material 20 is arranged on the base material 8 by filling the cavity 11 with the constituent material 20. Then, the electronic component 2 is held by a holding member and the electronic component 2 is mounted in the cavity 11. Next, as shown in Fig. 12, the electronic component 2 is pushed into the cavity 11 by a pressurized reflow apparatus 49 with respect to the electronic component 2, and the bonding material 4A and the bonding material 4B are brought into contact inside the constituent material 20. At this time, a part of the constituent material 20 is pushed out to the groove portion 30 (see Fig. 3). Next, the bonding material 4B of the electronic component 2 and the bonding material 4A of the base material 8 are bonded by heating. Thereby, the mounting board 1 is completed.

The circuit board 3 may include the bonding material 4A (first bonding material) containing a metal element arranged on the terminal 10A, and the bonding material 4A (second bonding material) containing a metal element arranged on the terminal 10B. In this case, the electronic component 2 can be mounted on the terminals 10A and 10B via the bonding material 4A.

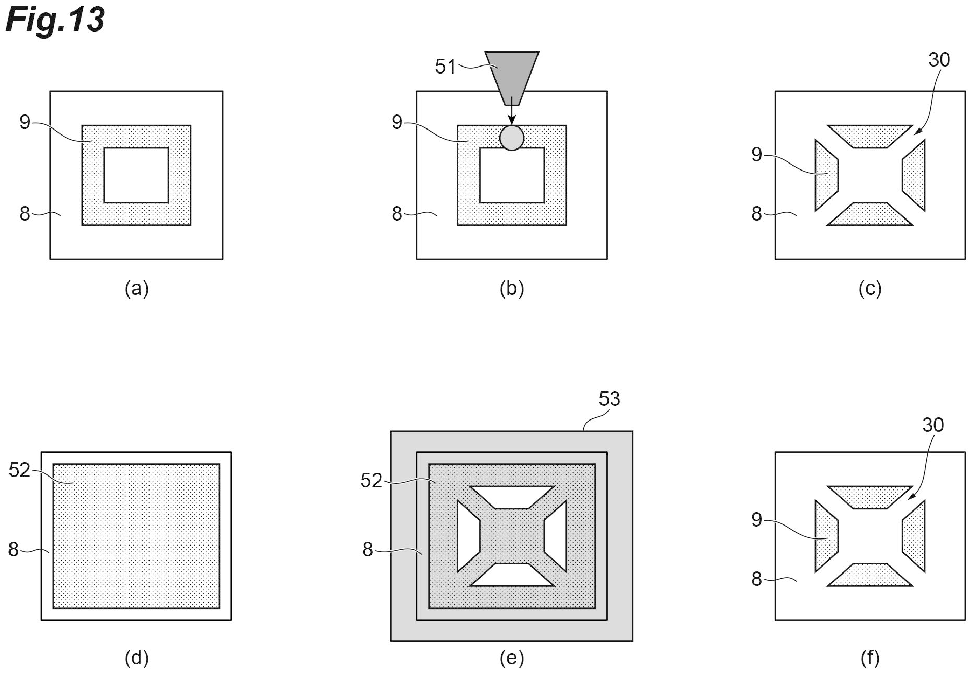

Next, a formation method of the wall 9 having the groove portion 30 will be described with reference to (a) to (f) parts of Fig. 13. First, as shown in (a) part of Fig. 13, the wall 9 is formed on the base material 8. Next, as shown in (b) part of Fig. 13, a part of the wall 9 is processed by irradiating the wall 9 with a laser using a laser apparatus 51. Thereby, as shown in (c) part of Fig. 13, the groove portion 30 is formed in the wall 9.

Alternatively, as shown in (d) part of Fig. 13, a resist 52 is formed on the base material 8. Next, as shown in (e) part of Fig. 13, exposure is performed using a glass mask 53 having a pattern corresponding to the shape of the wall 9 having the groove portion 30. As shown in (f) part of Fig. 13, the wall 9 having the groove portion 30 is formed by developing the resist 52 after exposure.

Note that when forming an undercut portion (depression portion as shown in Figs. 10(a) and 10(b)), the focus position of exposure may be shifted upward from the film surface. Alternatively, the undercut portion may be formed by over-developing. When the groove portion 30 does not reach the base material 8 as in Fig. 5(c) or the like, the groove portion 30 may be formed by scraping off only the surface of the wall 9 with a laser or the like.

Next, operations and effects of the circuit board 3 and the method for manufacturing the mounting board 1 according to the present embodiment will be described.

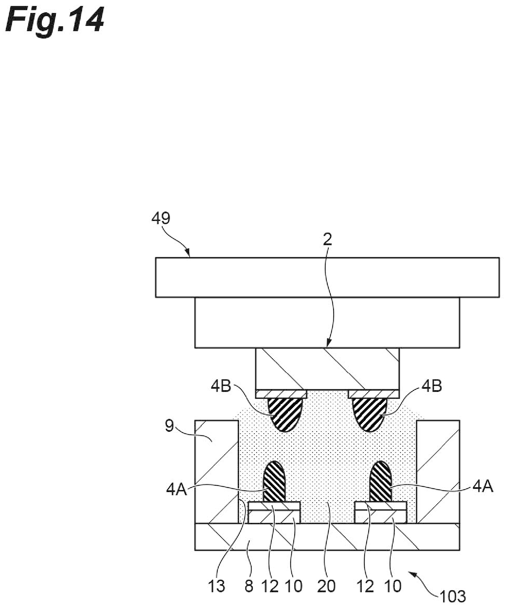

First, a circuit board 103 according to a comparative example will be described with reference to Fig. 14. The wall 9 of the circuit board 103 does not have the above-described groove portion 30. When the electronic component 2 is mounted in the wall 9 using a holding member after filling the inside of the wall 9 with the constituent material 20, and an attempt is made to push in the electronic component 2 with a pressurized reflow apparatus, the electronic component 2 cannot be sufficiently pushed in due to the influence of the surplus constituent material 20. In this case, reflow is performed in a state where the bonding material 4B of the electronic component 2 and the bonding material 4A of the circuit board 3 remain separated, and there is a possibility that a connection failure between the bonding material 4A of the circuit board 3 and the electronic component 2 occurs.

On the other hand, in the circuit board 3 according to the present embodiment, the pair of terminals 10 (first terminal and second terminal) are arranged in the cavity 11 surrounded by the wall 9. Here, the wall 9 has the groove portion 30 penetrating from the inner peripheral surface 13a to the outer peripheral surface 13b. In this case, when the electronic component 2 is mounted on the circuit board 3 by arranging the constituent material 20 in the cavity 11, mounting the electronic component 2 using a holding member, pushing the electronic component 2 into the inside of the cavity 11 using a pressurized reflow apparatus, heating, and bonding to the circuit board 3, the surplus constituent material 20 can be discharged to the outside of the wall 9 via the groove portion 30. Thereby, the electronic component 2 can be sufficiently pushed into the cavity 11 in the pressurizing step using the pressurized reflow apparatus, and brought into contact with the bonding material 4. Here, the cavity 11 in the wall 9 can be used as a mechanism for positioning the electronic component 2. When the inner peripheral surface 13a of the wall frame portion 13 has a large groove portion, there is a possibility that distortion occurs in the inner peripheral surface 13a. On the other hand, at least one of the corner portions 14 formed from two wall frame portions 13 among the walls 9 has the groove portion 30. In this case, since the wall frame portion 13 does not have a groove portion (even if it has, it can be made small), distortion of the inner peripheral surface 13a can be suppressed. Therefore, the electronic component 2 can be accurately positioned using the inner peripheral surface 13a of the wall frame portion 13. From the above, it is possible to suppress a connection failure between the circuit board 3 and the electronic component 2, and improve positional accuracy of the mounted electronic component 2.

The wall 9 has four corner portions 14 by having the wall frame portions 13 provided on four sides, and among the four corner portions 14, at least a pair of corner portions 14 on a diagonal may have the groove portion 30, or the four corner portions 14 may have the groove portion 30. Since the corner portion 14 of the cavity 11 is a location where the pressure of the constituent material 20 is most applied, by providing the groove portion 30 at the location, it becomes easy to pour the surplus constituent material 20. Also, since at least the pair of corner portions 14 on the diagonal have the groove portion 30, the surplus constituent material 20 can be flowed from the groove portion in a well-balanced manner.

When viewed from the extension direction of the groove portion 30, the groove portion 30 may extend from the tip portion 13c in the Z-axis direction (first direction) of the wall frame portion 13 toward the base material 8 side, and the bottom surface 30a of the groove portion 30 may be arranged at a position separated from the base material 8. In this case, since the wall frame portions 13 constituting the corner portion 14 are connected on the base material 8 side, the strength of the wall 9 can be improved, and the positioning accuracy by the cavity 11 can be improved.

At least any of the inner peripheral surface 13a, the outer peripheral surface 13b of the wall frame portion 13, and the side surface 30b of the groove portion 30 may have the depression portion 45 at a position on the base material 8 side in the Z-axis direction, and the cavity material 46 covering the base material 8 may be provided at the position of the depression portion 45. According to such a shape, the depression portion 45 can function as a guide groove through which the constituent material 20 passes at the position on the base material 8 side. Therefore, the fluidity of the constituent material 20 can be improved.

When the sum of areas of the inner peripheral surfaces 13a of the wall frame portions 13 when viewed from the thickness direction of the wall frame portions 13 in the wall 9 is S, the opening area of the groove portion 30 when viewed from the extension direction LD of the groove portion 30 in the wall 9 is Sc, the width of the bottom surface 30a of the groove portion 30 in the width direction WD orthogonal to the extension direction LD and the Z-axis direction is W2b, and the length of the groove portion 30 in the extension direction LD at the bottom surface 30a of the groove portion 30 is Lb, the following formula (1) and formula (2) may hold true. By satisfying formula (1), it is possible to suppress that the constituent material 20 becomes difficult to flow due to the ratio of the opening area being too small, and suppress that a necessary amount of the constituent material 20 flows out due to it being too large. Also, by satisfying formula (2), it is possible to suppress that the constituent material 20 becomes difficult to flow due to the width W2b becoming narrow relative to the length Lb which is the flow path length and pressure loss increasing, and suppress that a necessary amount of the constituent material flows out due to the width W2b being too wide. $0.004 \leq Sc / S < 0.6$ $0.1 \leq Σ \left(W2bn/Lbn\right) < 21.5$

When viewed from the thickness direction of the wall frame portion 13, the groove portion 30 may extend from the tip portion of the wall frame portion 13 in the first direction orthogonal to the main surface 8a of the base material 8 toward the base material 8 side, and the width of the groove portion 30 in the width direction orthogonal to the thickness direction and the first direction may be larger on the tip portion 13c side than on the bottom surface 30a side. In this case, by narrowing the groove portion 30 on the base material 8 side, flow path resistance increases and the necessary constituent material is held, and by widening the groove portion 30 on the tip portion side, it becomes easy to discharge the surplus constituent material.

When viewed from the Z-axis direction, regarding the width of the groove portion 30 in the width direction WD orthogonal to the extension direction LD of the groove portion 30 and the Z-axis direction, one of the outer peripheral side and the inner peripheral side may be larger than the other. In this case, the fluidity of the constituent material 20 flowing through the groove portion 30 from the inner peripheral side to the outer peripheral side can be controlled by the width of the groove portion 30. Also, thereby, distortion of the wall 9 can be suppressed and the positioning accuracy by the cavity 11 can be improved.

When viewed from the Z-axis direction, regarding the width of the groove portion 30 in the width direction W orthogonal to the extension direction LD of the groove portion 30 and the Z-axis direction, when the width on the inner peripheral side is W1, the width at the intermediate position in the extension direction is W2, and the width on the outer peripheral side is W3, one of "W1, W3 ≥ W2, W3 ≥ W1" or "W1, W3 ≥ W2, W1 ≥ W3" may hold true. In this case, the fluidity of the constituent material 20 flowing through the groove portion 30 from the inner peripheral side to the outer peripheral side can be controlled by the width at each position of the groove portion 30. Also, thereby, distortion of the wall 9 can be suppressed and the positioning accuracy by the cavity 11 can be improved.

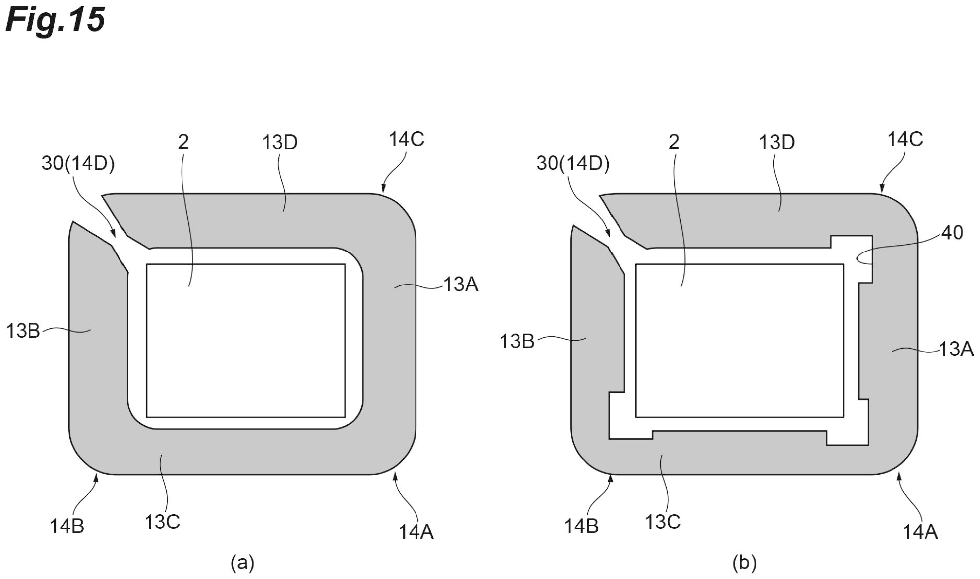

Among the corner portions 14, at least one of the corner portions 14 where the groove portion 30 is not formed may have the concave portion 40 recessed toward the outer peripheral side from the inner peripheral surface. For example, as shown in Fig. 15(a), when the corner portion does not have the concave portion 40, there is a possibility that the corner portion of the electronic component 2 and the corner portion in the cavity 11 interfere before the electronic component 2 and the inner peripheral surface come into contact. On the other hand, as shown in (b) part of Fig. 15, since the corner portion 14 of the cavity 11 has the concave portion 40, it is possible to suppress that the corner portion 14 of the cavity 11 interferes with the corner portion of the electronic component 2.

Roundness may be given to the edge portion of the groove portion 30. In this case, it is possible to suppress that the constituent material 20 at the time of flowing receives resistance at the edge portion or the like.

A method for manufacturing the mounting board 1 according to the present embodiment is for manufacturing the mounting board 1 by mounting the electronic component 2 on the above-described circuit board 3, wherein the constituent material 20 may be arranged on the base material 8, the electronic component 2 may be arranged, and thereafter the electronic component 2 may be bonded to the terminal 10 using the pressurized reflow apparatus 49.

In this case, operations and effects to the same effect as the above-described circuit board 3 can be obtained.

The present disclosure is not limited to the above-described embodiments. For example, the number and arrangement of terminals of the circuit board are not particularly limited. Also, in the above-described embodiment, one electronic component 2 was arranged in the wall 9, but a plurality of electronic components 2 may be arranged. The arrangement mode of the plurality of electronic components 2 is not particularly limited.

[Examples] Examples of the mounting board according to the present disclosure will be described. Note that the present disclosure is not limited to the following examples.

First, mounting boards of a comparative example and Examples 1 to 6 were created by the following manufacturing method. First, the circuit board 3 was obtained by forming the wall 9 having the groove portion 30 at the corner portion so as to surround the terminal 10 and the bonding material 4 on the base material 8. Next, the circuit board 3 was filled with the constituent material 20, and an LED chip was mounted as the electronic component 2. Next, the mounting board 1 in this state was pressurized at 0.01 MPa by the pressurized reflow apparatus 49 and reflowed at 150°C to 190°C. Thereby, the circuit board 3 and the electronic component 2 were bonded. Various conditions of the comparative example and Examples 1 to 6 are shown in Tables 1 to 3. Note that "Wall inner opening width Wi" in Table 1 is a dimension in the longitudinal direction of the reference shape T1 on the inner peripheral side of the wall 9 (see Fig. 3). "Wall inner opening width Li" is a dimension in the short direction of the reference shape T1 on the inner peripheral side of the wall 9 (see Fig. 3). "Wall frame width Top: Ltw" is a thickness at the wall frame portions 13C and 13D on the long side of the wall 9. "Wall frame width Tip: Ltl" is a thickness at the wall frame portions 13A and 13B on the short side of the wall 9. "Wall outer opening width Wo" is a dimension in the longitudinal direction of the reference shape T2 on the outer peripheral side of the wall 9 (see Fig. 3). "Wall outer opening width Lo" is a dimension in the short direction of the reference shape T2 on the outer peripheral side of the wall 9 (see Fig. 3). "Groove portion position" in Table 2 indicates the position of the groove portion 30. "None" means that the groove portion 30 is not formed, "Two corners" means that the groove portion 30 is formed at the corner portions 14A and 14D, "One corner" means that the groove portion 30 is formed at the corner portion 14D, and "Four corners" means that the groove portion 30 is formed at the four corner portions 14. "Groove portion Top width: W2t" is a width on the tip portion 13c side of the groove portion 30 (see Fig. 8). "Groove portion Bottom: W2b" is a width on the bottom surface 30a side of the groove portion 30 (see Fig. 8). "Wall height: H" is the height of the wall 9 (see Fig. 8). "Groove portion depth: Hs" is the depth of the groove portion 30 (see Fig. 8). "S", "Sc", "Sc/S", and "ΣW2bn/Lbn" in Table 3 correspond to the above-described formulas (1) and (2).

**[Table 1]**

| | Wall inner opening width :Wi | Wall inner opening width :Li | Wall frame width Top :Ltw | Wall frame width Top :Ltl | Wall outer opening width :Wo | Wall outer opening width :Lo |
|---|---|---|---|---|---|---|
| | *µ*m | *µ*m | *µ*m | *µ*m | *µ*m | *µ*m |
| Comparative Example | 19 | 12 | 7 | 7 | 33 | 26 |
| Example 1 | 19 | 12 | 7 | 7 | 33 | 26 |
| Example 2 | 19 | 12 | 7 | 7 | 33 | 26 |
| Example 3 | 19 | 12 | 7 | 7 | 33 | 26 |
| Example 4 | 19 | 12 | 7 | 7 | 33 | 26 |
| Example 5 | 19 | 12 | 7 | 7 | 33 | 26 |
| Example 6 | 19 | 8 | 7 | 7 | 30 | 22 |

**[Table 2]**

| | Groove portion position | Number of Groove portion | Groove portion Top width: W2t | Groove portion Bottom :W2b | Wall height :H | Groove portion depth: Hs |
|---|---|---|---|---|---|---|
| | - | Number | *µ*m | *µ*m | *µ*mt | *µ*mt |
| Comparative Example | None | 0 | 0 | - | 7 | 0 |
| Example 1 | Two corners (Upper left and Lower right) | 2 | 5 | 2 | 7 | 7 |
| Example 2 | One corner (Upper left) | 1 | 5 | 2 | 7 | 7 |
| Example 3 | Four corners | 4 | 4 | 1 | 7 | 7 |
| Example 4 | Four corners | 4 | 3 | 1 | 7 | 5 |
| Example 5 | Four corners | 4 | 3 | 1 | 7 | 5 |
| Example 6 | Four corners | 4 | 3 | 1 | 7 | 5 |

**[Table 3]**

| | S | Sc | Sc/S | Σ(W2bn/Lbn) | Wall peeling failure | Electronic component mounting rate | Number of mounted | OK |
|---|---|---|---|---|---|---|---|---|
| | *µ*m² | *µ*m² | - | | - | % | | |
| Comparative Example | 434.000 | 0.000 | 0 | | None | 10.7 | 28 | 3 |
| Example 1 | 434.000 | 49.000 | 0.113 | 0.404 | None | 100.0 | 28 | 28 |
| Example 2 | 434.000 | 24.500 | 0.056 | 0.202 | None | 100.0 | 28 | 28 |
| Example 3 | 434.000 | 70.000 | 0.161 | 0.404 | None | 100.0 | 28 | 28 |
| Example 4 | 434.000 | 40.000 | 0.092 | 0.404 | None | 100.0 | 28 | 28 |
| Example 5 | 434.000 | 40.000 | 0.092 | 0.404 | None | 100.0 | 28 | 28 |
| Example 6 | 336.000 | 40.000 | 0.119 | 0.404 | None | 100.0 | 28 | 28 |

Table 3 shows evaluation results of the comparative example and Examples 1 to 6. Note that the evaluation shown in Table 3 shows evaluation results when circuit boards 3 of the number of samples described in "Number of mounted" were created and the electronic component 2 was mounted in those circuit boards 3. "Wall peeling failure" in Table 3 indicates a result of whether or not there was a sample that caused a failure in which the wall 9 peeled off from the base material 8. In any of the comparative example and Examples 1 to 6, there was no peeling. "OK" indicates the number of samples in which the electronic component 2 could be mounted on the circuit board 3, and "Electronic component mounting rate" indicates a ratio of OK products to the number of samples. In the comparative example, the electronic component mounting rate was as low as 10.7%, whereas in any of Examples 1 to 6, the mounting rate was 100%.

[Aspect 1] A circuit board comprising:
   a base material having a main surface;
   a first terminal and a second terminal provided on the main surface of the base material; and
   one or more walls of an insulating material provided on the main surface of the base material,
   wherein the first terminal and the second terminal are arranged in a cavity surrounded by the wall, and at least one of corner portions formed by two wall frame portions of the wall has a groove portion penetrating from an inner peripheral surface to an outer peripheral surface.
[Aspect 2] The circuit board according to Aspect 1, wherein the wall has wall frame portions provided on four sides to have four corner portions, and
   wherein, of the four corner portions, at least a pair of the corner portions on a diagonal have the groove portion, or the four corner portions have the groove portion.
[Aspect 3] The circuit board according to Aspect 1 or 2, wherein when viewed from an extension direction of the groove portion, the groove portion extends from a tip portion of the wall frame portion in a first direction orthogonal to the main surface of the base material toward the base material side, and a bottom surface of the groove portion is positioned away from the base material.
[Aspect 4] The circuit board according to any one of Aspects 1 to 3, wherein at least any one of the inner peripheral surface of the wall frame portion, the outer peripheral surface of the wall frame portion, and a side surface of the groove portion has a depression portion positioned on the base material side in a first direction orthogonal to the main surface of the base material, and
   wherein a cavity material covering the base material is provided at a position of the depression portion.
[Aspect 5] The circuit board according to any one of Aspects 1 to 4, wherein when a sum of areas of the inner peripheral surface of the wall frame portion when viewed from a thickness direction of the wall frame portions in the wall is S, an opening area of the groove portion when viewed from an extension direction of the groove portion in the wall is Sc, a width of a bottom surface of the groove portion in a width direction orthogonal to the extension direction and a first direction orthogonal to the main surface of the base material is W2b, and a length of the groove portion in the extension direction at the bottom surface of the groove portion is Lb,
   the following formula (1) and formula (2) are satisfied. $0.004 \leq Sc / S < 0.6$ $0.1 \leq Σ \left(W2bn/Lbn\right) < 21.5$
[Aspect 6] The circuit board according to any one of Aspects 1 to 5, wherein when viewed from a thickness direction of the wall frame portion, the groove portion extends from a tip portion of the wall frame portion in a first direction orthogonal to the main surface of the base material toward the base material side, and a width of the groove portion in a width direction orthogonal to the thickness direction and the first direction is larger on a tip portion side than on a bottom surface side.
[Aspect 7] The circuit board according to any one of Aspects 1 to 6, wherein when viewed from a first direction orthogonal to the main surface of the base material, regarding a width of the groove portion in a width direction orthogonal to an extension direction of the groove portion and the first direction, one of the outer peripheral surface side and the inner peripheral surface side is larger than the other.
[Aspect 8] The circuit board according to any one of Aspects 1 to 7, wherein when viewed from a first direction orthogonal to the main surface of the base material, regarding a width of the groove portion in a width direction orthogonal to an extension direction of the groove portion and the first direction, when a width on the inner peripheral surface side is W1, a width at an intermediate position in the extension direction is W2, and a width on an outer peripheral surface side is W3, one of "W1, W3 ≥ W2, W3 ≥ W1" or "W1, W3 ≥ W2, W1 ≥ W3" is satisfied.
[Aspect 9] The circuit board according to any one of Aspects 1 to 8, wherein at least one of the corner portions where the groove portion is not formed of the corner portions has a concave portion recessed toward an outer peripheral surface side from the inner peripheral surface.
[Aspect 10] The circuit board according to any one of Aspects 1 to 9, wherein an edge portion of the groove portion is rounded.
[Aspect 11] A method for manufacturing a mounting board by mounting an electronic component on the circuit board according to any one of Aspects 1 to 10,
   wherein a constituent material is arranged on the base material, the electronic component is arranged, and thereafter the electronic component is bonded to the terminal using a pressurized reflow apparatus.

### Reference Signs List

- 1: Mounting board
- 2: Electronic component
- 3: Circuit board
- 4A: Bonding material
- 8: Base material
- 9: Wall
- 10: Terminal
- 11: Cavity
- 13: Wall frame portion
- 14: Corner portion
- 20: Constituent material
- 30: Groove portion
- 40: Concave portion
- 45: Depression portion
- 46: Cavity material
- 49: Pressurized reflow apparatus

## Claims

1. A circuit board comprising:
a base material having a main surface;
a first terminal and a second terminal provided on the main surface of the base material; and
one or more walls of an insulating material provided on the main surface of the base material,
wherein the first terminal and the second terminal are arranged in a cavity surrounded by the wall, and at least one of corner portions formed by two wall frame portions of the wall has a groove portion penetrating from an inner peripheral surface to an outer peripheral surface.

2. The circuit board according to claim 1, wherein the wall has wall frame portions provided on four sides to have four corner portions, and
wherein, of the four corner portions, at least a pair of the corner portions on a diagonal have the groove portion, or the four corner portions have the groove portion.

3. The circuit board according to claim 1, wherein when viewed from an extension direction of the groove portion, the groove portion extends from a tip portion of the wall frame portion in a first direction orthogonal to the main surface of the base material toward the base material side, and a bottom surface of the groove portion is positioned away from the base material.

4. The circuit board according to claim 1, wherein at least any one of the inner peripheral surface of the wall frame portion, the outer peripheral surface of the wall frame portion, and a side surface of the groove portion has a depression portion positioned on the base material side in a first direction orthogonal to the main surface of the base material, and
wherein a cavity material covering the base material is provided at a position of the depression portion.

5. The circuit board according to claim 1, wherein when a sum of areas of the inner peripheral surface of the wall frame portion when viewed from a thickness direction of the wall frame portions in the wall is S, an opening area of the groove portion when viewed from an extension direction of the groove portion in the wall is Sc, a width of a bottom surface of the groove portion in a width direction orthogonal to the extension direction and a first direction orthogonal to the main surface of the base material is W2b, and a length of the groove portion in the extension direction at the bottom surface of the groove portion is Lb,
the following formula (1) and formula (2) are satisfied. $0.004 \leq Sc / S < 0.6$ $0.1 \leq Σ \left(W2bn/Lbn\right) < 21.5$

6. The circuit board according to claim 1, wherein when viewed from a thickness direction of the wall frame portion, the groove portion extends from a tip portion of the wall frame portion in a first direction orthogonal to the main surface of the base material toward the base material side, and a width of the groove portion in a width direction orthogonal to the thickness direction and the first direction is larger on a tip portion side than on a bottom surface side.

7. The circuit board according to claim 1, wherein when viewed from a first direction orthogonal to the main surface of the base material, regarding a width of the groove portion in a width direction orthogonal to an extension direction of the groove portion and the first direction, one of the outer peripheral surface side and the inner peripheral surface side is larger than the other.

8. The circuit board according to claim 1, wherein when viewed from a first direction orthogonal to the main surface of the base material, regarding a width of the groove portion in a width direction orthogonal to an extension direction of the groove portion and the first direction, when a width on the inner peripheral surface side is W1, a width at an intermediate position in the extension direction is W2, and a width on an outer peripheral surface side is W3, one of "W1, W3 ≥ W2, W3 ≥ W1" or "W1, W3 ≥ W2, W1 ≥ W3" is satisfied.

9. The circuit board according to claim 1, wherein at least one of the corner portions where the groove portion is not formed of the corner portions has a concave portion recessed toward an outer peripheral surface side from the inner peripheral surface.

10. The circuit board according to claim 1, wherein an edge portion of the groove portion is rounded.

11. A method for manufacturing a mounting board by mounting an electronic component on the circuit board according to any one of claims 1 to 10,
wherein a constituent material is arranged on the base material, the electronic component is arranged, and thereafter the electronic component is bonded to the terminal using a pressurized reflow apparatus.
